# EUROPEAN PATENT SPECIFICATION

(11) **EP 2 183 749 B1**
(45) Date of publication and mention of the grant of the patent: **29.05.2013**
(21) Application number: 08782581.6
(22) Date of filing: 01.08.2008
(51) Int. Cl.: G11C 16/00, G11C 29/00, G11B 20/10, G11C 16/22

(54) **ENHANCED WRITE ABORT MECHANISM FOR NON-VOLATILE MEMORY**
ERWEITERTER SCHREIBABBRUCHMECHANISMUS FÜR EINEN NICHTFLÜCHTIGEN SPEICHER
MÉCANISME AMÉLIORÉ D'INTERRUPTION D'ÉCRITURE POUR MÉMOIRE NON VOLATILE

(30) Priority: 06.08.2007 US 890708; 06.08.2007 US 890734
(43) Date of publication of application: 12.05.2010
(73) Proprietor: SanDisk Technologies Inc., Plano, Texas 75024 (US)
(72) Inventor: SPROUSE, Steven, T., San Jose, CA 95129 (US); PARIKH, Dhaval, Santa Clara, CA 95051 (US); KAPOOR, Arjun, San Francisco, CA 94109 (US)
(74) Representative: Hitchcock, Esmond Antony
(86) International application number: PCT/US2008/071865
(87) International publication number: WO 2009/020845

(56) References cited:
- US-A1- 2005 146 954
- US-A1- 2006 034 120
- US-B1- 6 246 626
- US-B1- 6 266 277
- US-B1- 6 822 899
- US-B2- 6 819 622

## Description

### TECHNICAL FIELD

The present disclosure relates generally to write abort mechanisms for use with non-volatile memory.

### BACKGROUND

Binary and Multi-Level Cell (MLC) NAND Flash Memory are forms of non-volatile memory (NVM) that are capable of high data storage densities and high performance, however, a power failure due to hot removal, brownout, blackout or the like can cause data corruption or loss due to the nature of the way in which data is written to this type of memory. Typically a "page" or group of bits at a time is written to the NVM. If a power failure occurs during a write cycle/program operation, something less than all of the bits of the page may be programmed successfully in the NVM. When the page containing unsuccessfully programmed bits is read back, some bits will have the new value, some will have the old value and, as a result, the page will be corrupted. In some prior approaches, complex data structures and multiple copies of host data are kept on the NVM device to ensure graceful recovery under most circumstance. This approach, unfortunately, reduces performance and data storage densities. An NVM program cycle using Flash-type memory, for example, typically takes on the order of 0.5 -10 mSec, depending upon the type of memory.

This problem can be addressed through the use of a backup or secondary power source arranged to directly power the NVM such as a battery or very large-valued capacitor (on the order of 1000's of uF). but these solutions are often costly or require too much space. An improved solution would be desirable.
US 6 882 899 as well as US 2005/0146984 disclose a non-volatile memory in which, in reponse to detection of a power supply voltage drop, an ongoing write operation is completed using remaining power from the power supply.

### BRIEF SUMMARY

In a non-volatile memory (NVM) device having a controller and a non-volatile memory array controlled by the controller a voltage supervisor circuit monitors an output of a voltage supply powering the NVM device. The voltage supervisor circuit may be part of the NVM device or coupled to it. The voltage supervisor circuit is configured to assert a "low-voltage" signal responsive to detecting the output of the voltage supply powering the NVM device dropping below a predetermined value. The controller is configured to write data into the memory array while the "low-voltage" signal is deasserted and to suspend writing data while the "low-voltage" signal is asserted. In response to assertion of the "low-voltage" signal, the controller completes a write cycle/NVM program operation, if pending, and prevents any additional write cycles/program operation(s) during assertion of the "low-voltage" signal. In one embodiment a method for carrying out a write-abort process to suspend attempts by a memory controller to write data into a non-volatile memory array during low-voltage conditions is disclosed. The method may include monitoring an output of a voltage supply powering the non-volatile memory array, determining if a low-voltage condition exists at the output of the voltage supply, and suspending any unprocessed write commands while the low-voltage condition exists. Also disclosed is a non-volatile memory apparatus including a non-volatile memory array. The non-volatile memory apparatus may also include a voltage supervisor circuit configured to monitor an output of a voltage supply powering the apparatus and to assert a signal in response to detecting the output of the voltage supply in a low-voltage state. Additionally, a memory controller may be included that is in communication with the memory array and configured to write data into the memory array while the signal is deasserted and to suspend writing data in response to assertion of the signal.

### BRIEF DESCRIPTION OF THE DRAWING

The accompanying drawings, which are incorporated into and constitute a part of this specification, illustrate one or more examples of embodiments and, together with the description of example embodiments, serve to explain the principles and implementations of the embodiments.

In the drawings:
FIG. 1 is a voltage/time plot which illustrates graphically a power-off profile for one typical power supply from a personal computer.
FIG. 2 is a similar voltage/time plot which illustrates graphically a power-off profile for another typical power supply from a personal computer.
FIG. 3 illustrates a schematic block diagram of a non-volatile (NVM) memory device coupled to a host in accordance with one embodiment.
FIG. 4 illustrates an ideal voltage/time plot and the time available for completing a pending write operation in accordance with one embodiment.

### DESCRIPTION OF EXAMPLE EMBODIMENTS

Example embodiments are described herein in the context of a non-volatile memory device of the type having a controller controlling the reading and writing of data from/to an associated non-volatile memory array. Those of ordinary skill in the art will realize that the following description is illustrative only and is not intended to be in any way limiting. Other embodiment will readily suggest themselves to such skilled persons having the benefit of this disclosure. Reference will now be made in detail to implementations of the example embodiments as illustrated in the accompanying drawings. The same preference indicators will be used throughout the drawings and the following description to refer to the same or like items.

In the interest of clarity, not all of the routine features of the implementations described herein are shown and described. It will, of course, be appreciated that in the development of any such actual implementation, numerous implementation-specific decisions must be made in order to achieve the developer's specific goals, such as compliance with application- and business-related constraints, and that these specific goals will vary from one implementation to another and from one developer to another. Moreover, it will be appreciated that such a development effort might be complex and time-consuming, but would nevertheless be a routine undertaking of engineering for those of ordinary skill in the art having the benefit of this disclosure.

In accordance with this disclosure, the components, process steps, and/or data structures described herein may be implemented using various types of operating systems, computing platforms, computer programs, and/or general purpose machines. In addition, those of ordinary skill in the art will recognize that devices of a less general purpose nature, such as hardwired devices, field programmable gate arrays (FPGAs), application specific integrated circuits (ASICs), or the like, may also be used without departing from the scope and spirit of the inventive concepts disclosed herein. Where a method comprising a series of process steps is implemented by a computer or a machine and those process steps can be stored as a series of instructions readable by the machine, they may be stored on a tangible medium such as a computer memory device (e.g., ROM (Read Only Memory), PROM (Programmable Read Only Memory), EEPROM (Electrically Eraseable Programmable Read Only Memory), FLASH Memory, Jump Drive, and the like), magnetic storage medium (e.g., tape, magnetic disk drive, and the like), optical storage medium (e.g., CD-ROM, DVD-ROM, paper card, paper tape and the like) and other types of program memory.

In embedded applications of NVM, where hot removal is not a substantial issue (e.g., due to the memory device being relatively inaccessible, soldered in place, or the like) it is possible to leverage the inherent capacitance of the system (e.g., power supply capacitors and printed circuit board capacitance) to allow for successful completion of "pending" or in-process NVM program or write cycle.

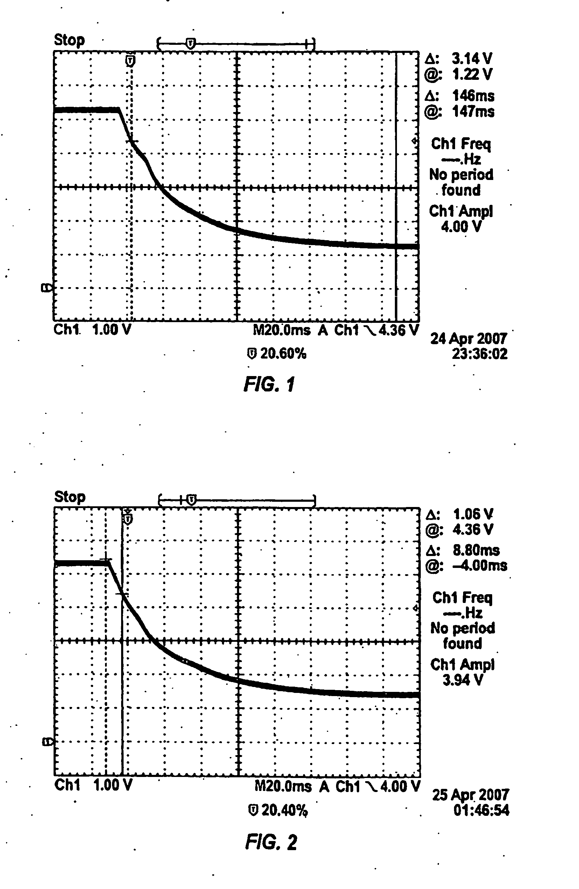

Turning to FIGS. 1 and 2, FIG. 1 is a voltage/time plot which graphically illustrates a power-off profile for one typical power supply from a personal computer. FIG. 2 is a similar voltage/time plot which graphically illustrates a power-off profile for another typical power supply from a personal computer. In each case, the vertical scales are 1 Volt DC (VDC) per division and the horizontal scales are 20 mSec per division. Of interest is the fact that upon being turned off, the power supply is able to hold the voltage for almost two divisions, then the voltage starts to drop. The voltage spends approximately 25 mSec in the voltage range between 4.5 VDC and 2.7 VDC. In one embodiment it is expected that NVM should be able to complete a write cycle/program operation in approximately 0.5 - 5 mSec, thus if the memory were to complete a current write cycle/program operation and begin no other write cycles/program operation(s) while the power was interrupted, data corruption problems could be obviated in such applications of NVM.

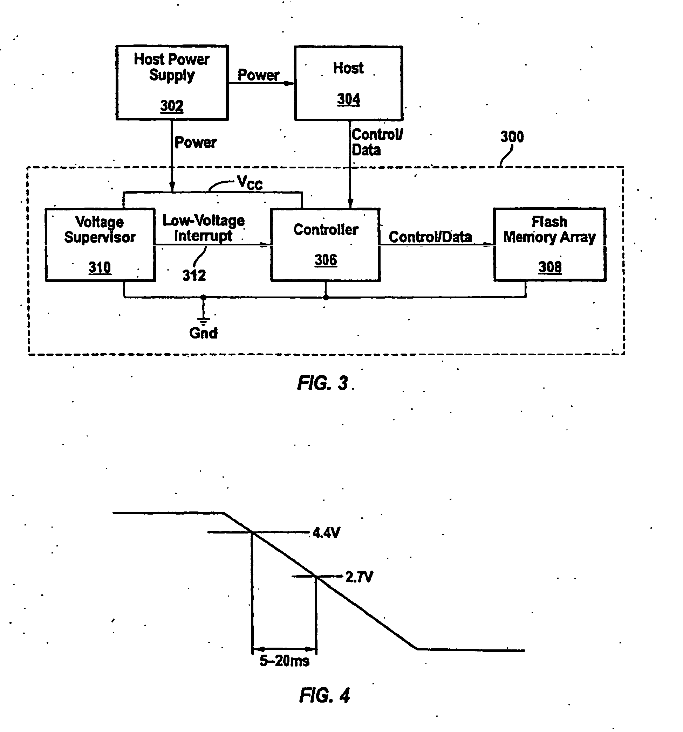

To utilize this feature of large power supplies, a voltage supervisor circuit 304, as shown in FIG. 3, is used to detect when the voltage has dropped significantly - here to a predetermined level of below 4.5 VDC (from just above 5.0 VDC). At that point, the voltage supervisor circuit is configured to assert a "low voltage signal" indicative of the below normal voltage output of the power supply to alert the NVM controller to suspend further writes to the NVM memory array. This approach takes full advantage of the fact that even though the specified Vcc_min is 4.5 VDC, the controller and memory will continue to function (in one embodiment) until the voltage drops to approximately 2.7 VDC. If the ramp down rate is sufficiently low, as shown in FIG. 4, e.g., 4.4 VDC to 2.7 VDC in about 5 - 20 mSec in one embodiment, then there will be enough time to complete a pending write cycle/program operation and further write cycles/program operation(s) will be suspended while the "low-voltage" signal continues to be asserted by the voltage supervisor circuit 304. Implementation of the voltage supervisor circuit 304 may be made in any convenient manner known to those of skill in the art.

In FIG. 3 a system bock diagram illustrates a configuration of an NVM device 300 coupled to a host power supply 302 and a host device 304. The host power supply 302 and host device 304 are of conventional design. The NVM device 300 comprises a non-volatile memory controller 306, flash memory array 308 and voltage supervisor circuit 310. Upon detecting an output voltage of the power supply (Vcc-GND) lower than a predetermined value (here we use the example 4.4 VDC in a 5 VDC system), the voltage supervisor circuit 310 in one embodiment asserts a "low-voltage" signal or "interrupt" on line 312. The controller 306, responsive to the assertion of this signal, completes any pending (e.g., already started) write cycles/NVM program operation and then (in one embodiment) executes a repetitive algorithm or loop to repetitively check to see if the low-voltage signal has been deasserted, as would occur if a blackout/brownout resolved itself before causing a complete power shutdown. The result of running this repetitive algorithm is to lock up the controller 306 so that no further write cycles/program operation(s) may be started (without causing it to reset). Of course, if the power is not restored, the controller 306 will eventually reset due to lack of power, but because many power glitches are quickly resolved, this approach protects the memory contents while avoiding unnecessary resets. In another embodiment, the "low-voltage" signal is applied as a standard flash memory control signal known as the "ready/busy" or "rb" signal. In accordance with this approach, if the voltage supervisor 310 were to detect a low-voltage condition and thus assert this signal, the flash memory array 308 would complete any pending write cycles/program operation(s), and internally it would deassert its "ready/busy" line to signal to the controller 306 that it was ready to execute another command (e.g., another write). However, the voltage supervisor 310, by asserting "ready/busy" to the controller 306, can, in effect, override the signal from the flash memory array 308 and thereby prevent the memory from effectively signaling that it is ready.
In this way controller 306 is tricked into concluding that the memory is still busy (i.e., until the voltage supervisor 310 deasserts "ready/busy" to the controller 306).

In accordance with various embodiments, the voltage supervisor circuit 304 may be external to a package (such as, for example, a multi-chip module or other packaging technology supporting and interconnecting multiple circuit components) or die (i.e., a die from a semiconductor wafer) comprising the flash memory array 308 and controller 306 (the package or die receiving the low-voltage signal via an electrical coupling to the external voltage supervisor 310), or the voltage supervisor circuit 310 may be integrated into a package or die comprising the flash memory array 308 and controller 306, the voltage supervisor circuit 310 implemented as a part of the package or die itself, receiving the +Vcc and GND power signals from a power supply which is external to the package or die (e.g., from a host powder supply 302). Similarly, the flash memory array 308 and the voltage supervisor 310 may be integrated together into a single package or die and coupled to an external controller 306. In such an implementation, a low-voltage condition is detected at the package/die comprising the array/voltage supervisor and the voltage supervisor signals back to the external controller 306. It is also contemplated that the controller 306 and voltage supervisor 310 may be integrated together in a single package/die apart from the flash memory array 308.

Note that in the implementation shown in FIG. 3, power line Vcc is not provided directly to flash memory array 308 but power provided to the flash memory array 308 is provided from controller 306 through the control/data line coupling controller 306 to flash memory array 308.

While embodiments and applications have been shown and described, it would be apparent to those skilled in the art having the benefit of this disclosure that many more modifications than mentioned above are possible without departing from the inventive concepts disclosed herein. The invention, therefore, is not to be restricted except in the scope of the appended claims.

## Claims

1. A method for carrying out a write abort process to suspend attempts by a memory controller (308) to write data into as non-volatile memory array (308) during low-voltage conditions, the method comprising:
monitoring an output of a voltage supply (302) powering the non-volatile memory array (308);
determining if a low-voltage condition exists at the output of the voltage supply (302);
subsequent to determining that the low-voltage condition exits, completing any write cycle already started prior to detection of the low-voltage condition using remaining power from the voltage supply (302); and
suspending any unprocessed write commands while the low-voltage condition exists.

2. The method of claim 1, wherein monitoring the output of the voltage supply (302) comprises monitoring the output of the voltage supply (302) with a voltage supervisor circuit (310).

3. The method of claim 1, wherein determining if the low-voltage condition exists comprises:
detecting for the low-voltage condition at the output of the voltage supply (302) with a voltage supervisor circuit (310) and, if the low-voltage condition is detected, asserting a low-volage condition signal.

4. The method of claim 3, wherein suspending any unprocessed write commands comprises the memory controller (306) repetitively executing an algorithm to check for deassertion of the low-voltage condition signal until the row-voltage condition signal is deasserted.

5. The method of Claim 2, wherein determining if the low voltage condition exists comprises detecting the low-voltage condition of the voltage supply (302) with the voltage supervisor circuit (310) and, responsive thereto, asserting a low-voltage condition signal on a ready/busy signal line of the memory controller (306).

6. The method of Claim 5, wherein suspending any unprocessed write commands while the low-voltage condition exists comprises:
suspending any unprocessed write commands while the low-voltage condition signal is asserted on the ready/busy signal line by causing the memory controller (306) to treat the non-volatile memory array (308) as busy in response to assertion of the low-voltage condition signal on the ready/busy signal line of the memory controller (306) and to continue treating the non-volatile memory array (306) as busy until the low-voltage condition signal is deasserted.

7. A non-volatile memory apparatus, comprising:
a non-volatile memory array (306);
a volage supervisor circuit (310) configured for monitoring an output of a voltage supply (302) powering the apparatus and to assert a low-voltage condition signal in response to detecting the output of the voltage supply (302) in a low voltage state; and
a memory controller (306) in communication with the non-volatile memory array (308) and configured to, subsequent to receipt of the low-voltage condition signal, complete any write cycle already started prior to receipt of the low-voltage condition signal using remaining power from the voltage supply (302) **characterized in that** the memory controller (306) is adapted to suspend writing data for any subsequent write cycles while the low-voltage condition signal remains asserted.

8. The apparatus of Claim 7, wherein the non-volatile memory array (308), memory controller (306) and voltage supervisor circuit (310) are integrated into a single package (300).

9. The apparatus of Claim 7, wherein the non-volatile memory array (308), memory controller (306) and voltage supervisor circuit (310) are integrated into a single die (300).

10. The apparatus of Claim 7, wherein the non-volatile memory array (308) and memory controller (306) are integrated into a single package and the voltage supervisor circuit (310) is external to that package.

11. The apparatus of Claim 7, wherein the non-volatile memory array (308) and memory controller (306) are integrated into a single die and the voltage supervisor circuit (310) is external to that die.

12. The apparatus of Claim 7, wherein the non-volatile memory array (308) and the voltage supervisor circuit (310) are integrated into a single package and the memory controller (306) is external to that package.

13. The apparatus of Claim 7, wherein the voltage supervisor circuit (310) and the memory controller (306) are integrated into a single package and the non-volatile memory array (308) is external to that package.

14. The apparatus of any of Claims 7 to 13, wherein the memory controller (306) is configured to suspend writing data by checking the status of the low-voltage condition signal until the low-voltage condition signal is deasserted.

15. The apparatus of any of Claims 7 to 13, wherein the memory controller (306) is configured to suspend writing data in response to the assertion of the low-volage condition signal on a ready/busy signal line of the memory controller (306) until the low-voltage condition signal is deasserted.

## Patentansprüche

1. Verfahren zum Durchführen eines Schreibabbruchprozesses, um Versuche durch einen Speichercontroller (306), während Niedrigspannungsbedingungen Daten in eine nichtflüchtige Speicheranordnung (308) zu schreiben, auszusetzen, wobei das Verfahren umfasst:
Überwachen eines Ausgangs einer Spannungsversorgung (302), welche die nichtflüchtige Speicheranordnung (308) mit Strom versorgt;
Bestimmen, ob eine Niedrigspannungsbedingung am Ausgang der Spannungsversorgung (302) besteht;
anschließend an das Bestimmen, dass die Niedrigspannungsbedingung besteht, Abschließen eines jeglichen bereits vor der Ermittlung der Niedrigspannungsbedingung begonnenen Schreibzyklus unter Verwendung von verbleibender Leistung von der Spannungsversorgung (302); und
Aussetzen jeglicher nicht verarbeiteten Schreibbefehle, solange die Niedrigspannungsbedingung besteht.

2. Verfahren nach Anspruch 1, worin das Überwachen des Ausgangs der Spannungsversorgung (302) umfasst: Überwachen des Ausgangs der Spannungsversorgung (302) mit einer Spannungsbeaufsichtigungsschaltung (310).

3. Verfahren nach Anspruch 1, worin das Bestimmen, ob die Niedrigspannungsbedingung besteht, umfasst:
Ermitteln der Niedrigspannungsbedingung am Ausgang der Spannungsversorgung (302) mit einer Spannungsbeaufsichtigungsschaltung (310), und wenn die Niedrigspannungsbedingung ermittelt wird, Aktivieren eines Niedrigspannungsbedingungssignals.

4. Verfahren nach Anspruch 3, worin das Aussetzen jeglicher nicht verarbeiteten Schreibbefehle umfasst: wiederholendes Ausführen eines Algorithmus durch den Speichercontroller (306), um auf Deaktivierung des Niedrigspannungsbedingungssignals zu prüfen, bis das Niedrigspannungsbedingungssignal deaktiviert wird.

5. Verfahren nach Anspruch 2, worin das Bestimmen, ob die Niedrigspannungsbedingung besteht, umfasst: Ermitteln der Niedrigspannungsbedingung der Spannungsversorgung (302) mit der Spannungsbeaufsichtigungsschaltung (310) und als Antwort darauf Aktivieren eines Niedrigspannungsbedingungssignals auf einer Bereit/Belegt-Signalleitung des Speichercontrollers (306).

6. Verfahren nach Anspruch 5, worin das Aussetzen jeglicher nicht verarbeiteten Schreibbefehle, solange die Niedrigspannungsbedingung besteht, umfasst:
Aussetzen jeglicher nicht verarbeiteten Schreibbefehle, solange das Niedrigspannungsbedingungssignal auf der Bereit/Belegt-Signalleitung aktiviert ist, indem bewirkt wird, dass der Speichercontroller (306) als Antwort auf die Aktivierung des Niedrigspannungsbedingungssignals auf der Bereit/Belegt-Signalleitung des Speichercontrollers (306) die nichtflüchtige Speicheranordnung (308) als belegt behandelt und fortfährt, die nichtflüchtige Speicheranordnung (308) als belegt zu behandeln, bis das Niedrigspannungsbedingungssignal deaktiviert wird.

7. Nichtflüchtige Speichervorrichtung, umfassend:
eine nichtflüchtige Speicheranordnung (308);
eine Spannungsbeaufsichtigungsschaltung (310), die dafür konfiguriert ist, einen Ausgang einer Spannungsversorgung (302), welche die Vorrichtung mit Strom versorgt, zu überwachen und als Antwort auf das Ermitteln des Ausgangs der Spannungsversorgung (302) in einem Niedrigspannungszustand ein Niedrigspannungsbedingungssignal zu aktivieren; und
einen Speichercontroller (306) in Kommunikation mit der nichtflüchtigen Speicheranordnung (308) und dafür konfiguriert, anschließend an den Empfang des Niedrigspannungsbedingungssignals jeglichen bereits vor dem Empfang des Niedrigspannungsbedingungssignals begonnenen Schreibzyklus unter Verwendung von verbleibender Leistung von der Spannungsversorgung (302) abzuschließen, **dadurch gekennzeichnet, dass** der Speichercontroller (306) dafür eingerichtet ist, das Schreiben von Daten für jegliche anschließenden Schreibzyklen auszusetzen, solange das Niedrigspannungsbedingungssignal aktiviert bleibt.

8. Vorrichtung nach Anspruch 7, worin die nichtflüchtige Speicheranordnung (308), der Speichercontroller (306) und die Spannungsbeaufsichtigungsschaltung (310) in ein einziges Gehäuse (300) integriert sind.

9. Vorrichtung nach Anspruch 7, worin die nichtflüchtige Speicheranordnung (308), der Speichercontroller (306) und die Spannungsbeaufsichtigungsschaltung (310) in einen einzigen Chip (300) integriert sind.

10. Vorrichtung nach Anspruch 7, worin die nichtflüchtige Speicheranordnung (308) und der Speichercontroller (306) in ein einziges Gehäuse integriert sind und die Spannungsbeaufsichtigungsschaltung (310) außerhalb dieses Gehäuses ist.

11. Vorrichtung nach Anspruch 7, worin die nichtflüchtige Speicheranordnung (308) und der Speichercontroller (306) in einen einzigen Chip integriert sind und die Spannungsbeaufsichtigungsschaltung (310) außerhalb dieses Chips ist.

12. Vorrichtung nach Anspruch 7, worin die nichtflüchtige Speicheranordnung (308) und die Spannungsbeaufsichtigungsschaltung (310) in ein einziges Gehäuse integriert sind und der Speichercontroller (306) außerhalb dieses Gehäuses ist.

13. Vorrichtung nach Anspruch 7, worin die Spannungsbeaufsichtigungsschaltung (310) und der Speichercontroller (306) in ein einziges Gehäuse integriert sind und die nichtflüchtige Speicheranordnung (308) außerhalb dieses Gehäuses ist.

14. Vorrichtung nach einem der Ansprüche 7 bis 13, worin der Speichercontroller (306) dafür konfiguriert ist, das Schreiben von Daten durch Prüfen des Status des Niedrigspannungsbedingungssignals auszusetzen, bis das Niedrigspannungsbedingungssignal deaktiviert wird.

15. Vorrichtung nach einem der Ansprüche 7 bis 13, worin der Speichercontroller (306) dafür konfiguriert ist, das Schreiben von Daten als Antwort auf die Aktivierung des Niedrigspannungsbedingungssignals auf einer Bereit/Belegt-Signalleitung des Speichercontrollers (306) auszusetzen, bis das Niedrigspannungsbedingungssignal deaktiviert wird.

## Revendications

1. Procédé de mise en oeuvre d'un processus d'interruption d'écriture destiné à suspendre les tentatives, exécutées par un contrôleur de mémoire (306), visant à écrire des données dans une matrice de mémoire non volatile (308) au cours d'états de basse tension, le procédé comprenant :
la surveillance d'une sortie d'une alimentation en tension (302) alimentant la matrice de mémoire non volatile (308) ;
la détermination de la présence ou de l'absence d'un état de basse tension au niveau de la sortie de l'alimentation en tension (302) ;
subséquemment à la détermination de la présence de l'état de basse tension, l'achèvement de tout cycle d'écriture commencé avant la détection de l'état de basse tension, en utilisant l'énergie restante provenant de l'alimentation en tension (302) ; et
la suspension des éventuelles commandes d'écriture non traitées en présence de l'état de basse tension.

2. Procédé selon la revendication 1, dans lequel la surveillance de la sortie de l'alimentation en tension (302) comprend la surveillance de la sortie de l'alimentation en tension (302) au moyen d'un circuit superviseur de tension (310).

3. Procédé selon la revendication 1, dans lequel la détermination de la présence ou absence de l'état de basse tension comporte :
la détection de l'état de basse tension au niveau de la sortie de l'alimentation en tension (302) au moyen d'un circuit superviseur de tension (310) et, si l'état de basse tension est détecté, l'affirmation d'un signal d'état de basse tension.

4. Procédé selon la revendication 3, dans lequel la suspension des éventuelles commandes d'écriture non traitées comporte l'exécution, de manière répétée, par le contrôleur de mémoire (306), d'un algorithme destiné à vérifier l'infirmation du signal d'état de basse tension jusqu'à ce que le signal d'état de basse tension soit infirmé.

5. Procédé selon la revendication 2, dans lequel la détermination de la présence ou absence de l'état de basse tension comprend la détection de l'état de basse tension de l'alimentation en tension (302) au moyen du circuit superviseur de tension (310) et, en réponse à cela, l'affirmation d'un signal d'état de basse tension sur une ligne de signal de disponibilité / occupation du contrôleur de mémoire (306).

6. Procédé selon la revendication 5, dans lequel la suspension des éventuelles commandes d'écriture non traitées en présence de l'état de basse tension comprend :
la suspension des éventuelles commandes d'écriture non traitées tant que le signal d'état de basse tension est affirmé sur la ligne de signal de disponibilité / occupation, en amenant le contrôleur de mémoire (306) à traiter la matrice de mémoire non volatile (308) en tant que matrice occupée, en réponse à l'affirmation du signal d'état de basse tension sur la ligne de signal de disponibilité / occupation du contrôleur de mémoire (306), et à continuer à traiter la matrice de mémoire non volatile (308) en tant que matrice occupée jusqu'à ce que le signal d'état de basse tension soit infirmé.

7. Dispositif de mémoire non volatile, comprenant :
une matrice de mémoire non volatile (308) ;
un circuit superviseur de tension (310) configuré de manière à surveiller une sortie d'une alimentation en tension (302) alimentant le dispositif et à affirmer un signal d'état de basse tension en réponse à la détection de la sortie de l'alimentation en tension (302) dans un état de tension basse ; et
un contrôleur de mémoire (306) en communication avec la matrice de mémoire non volatile (308), et configuré de manière à, subséquemment à la réception du signal d'état de basse tension, achever tout cycle d'écriture déjà commencé avant la réception du signal d'état de basse tension, en utilisant l'énergie restante de l'alimentation en tension (302), **caractérisé en ce que** le contrôleur de mémoire (306) est apte à suspendre l'écriture de données pour les éventuels cycles d'écritures subséquents alors que le signal d'état de basse tension reste affirmé.

8. Dispositif selon la revendication 7, dans lequel la matrice de mémoire non volatile (308), le contrôleur de mémoire (306) et le circuit superviseur de tension (310) sont intégrés dans un boîtier unique (300).

9. Dispositif selon la revendication 7, dans lequel la matrice de mémoire non volatile (308), le contrôleur de mémoire (306) et le circuit superviseur de tension (310) sont intégrés dans une puce unique (300).

10. Dispositif selon la revendication 7, dans lequel la matrice de mémoire non volatile (308) et le contrôleur de mémoire (306) sont intégrés dans un boîtier unique, et le circuit superviseur de tension (310) est extérieur à ce boîtier.

11. Dispositif selon la revendication 7, dans lequel la matrice de mémoire non volatile (308) et le contrôleur de mémoire (306) sont intégrés dans une puce unique, et le circuit superviseur de tension (310) est extérieur à cette puce.

12. Dispositif selon la revendication 7, dans lequel la matrice de mémoire non volatile (308) et le circuit superviseur de tension (310) sont intégrés dans un boîtier unique, et le contrôleur de mémoire (306) est extérieur à ce boîtier.

13. Dispositif selon la revendication 7, dans lequel le circuit superviseur de tension (310) et le contrôleur de mémoire (306) sont intégrés dans un boîtier unique, et la matrice de mémoire non volatile (308) est extérieure à ce boîtier.

14. Dispositif selon l'une quelconque des revendications 7 à 13, dans lequel le contrôleur de mémoire (306) est configuré de manière à suspendre l'écriture de données en vérifiant l'état du signal d'état de basse tension, jusqu'à ce que le signal d'état de basse tension soit infirmé.

15. Dispositif selon l'une quelconque des revendications 7 à 13, dans lequel le contrôleur de mémoire (306) est configuré de manière à suspendre l'écriture de données
en réponse à l'affirmation du signal d'état de basse tension sur une ligne de signal de disponibilité / occupation du contrôleur de mémoire (306), jusqu'à ce que le signal d'état de basse tension soit infirmé.
